# EUROPEAN PATENT SPECIFICATION

(11) **EP 3 948 633 B1**
(45) Date of publication and mention of the grant of the patent: **10.07.2024**
(21) Application number: 20720999.0
(22) Date of filing: 27.03.2020
(51) Int. Cl.: G06F 30/00, G06N 5/02, H04W 4/38, H04L 67/12

(54) **DIGITAL TWIN SYSTEM WITH ENERGY HARVESTING SENSOR DEVICES**
DIGITALES ZWILLINGSSYSTEM MIT ENERGIEGEWINNUNGSSENSORVORRICHTUNGEN
SYSTÈME DE JUMEAU NUMÉRIQUE AVEC DISPOSITIFS CAPTEURS DE COLLECTE D'ÉNERGIE

(30) Priority: 29.03.2019 US 201962826183 P
(43) Date of publication of application: 09.02.2022
(73) Proprietor: Smartrac Technology Fletcher, Inc., Fletcher, NC 28732 (US)
(72) Inventor: BARR, William, Nutley, NJ 07110 (US); HUANG, Bin, Cypress, CA 90630 (US)
(74) Representative: HGF
(86) International application number: PCT/US2020/025145
(87) International publication number: WO 2020/205484

(56) References cited:
- EP-A1- 3 208 757
- CN-A- 110 717 985
- US-A1- 2016 247 129
- US-A1- 2016 357 525
- US-A1- 2018 054 376
- US-A1- 2018 152 518
- US-A1- 2018 210 436
- FDA: "Radio Frequency Identification (RFID)", 17 September 2018 (2018-09-17), pages 1 - 4, XP093009415, Retrieved from the Internet <URL:https://www.fda.gov/radiation-emitting-products/electromagnetic-compatibility-emc/radio-frequency-identification-rfid> [retrieved on 20221219]
- LEI ZHANG ET AL: "Integration of RFID into Wireless Sensor Networks: Architectures, Opportunities and Challenging Problems", GRID AND COOPERATIVE COMPUTING WORKSHOPS, 2006. GCCW '06. FIFTH I NTERNATIONAL CONFERENCE ON, IEEE, PI, 1 October 2006 (2006-10-01), pages 463 - 469, XP031031169, ISBN: 978-0-7695-2695-9
- XIN SHI ET AL: "The integration of Wireless Sensor Networks and RFID for pervasive computing", COMPUTER SCIENCES AND CONVERGENCE INFORMATION TECHNOLOGY (ICCIT), 2010 5TH INTERNATIONAL CONFERENCE ON, IEEE, 30 November 2010 (2010-11-30), pages 67 - 72, XP031912904, ISBN: 978-1-4244-8567-3, DOI: 10.1109/ICCIT.2010.5711031
- TOLCHA YALEW ET AL: "Distributed event-based resource-oriented EPCglobal middleware using GPC", 2016 IEEE INTERNATIONAL CONFERENCE ON RFID TECHNOLOGY AND APPLICATIONS (RFID-TA), IEEE, 21 September 2016 (2016-09-21), pages 29 - 34, XP033004201, DOI: 10.1109/RFID-TA.2016.7750734

## Description

### CROSS-REFERENCE TO RELATED APPLICATIONS

### BACKGROUND

The present disclosure addresses digital twins based on energy harvesting, battery-less, contactless transmitted sensor data and methods of communicating and fusing the data.

A digital twin is a digital representation of a physical object or space and all of its contents and/or a representation of a set of sensor data. The digital twin can include both physical object data, such as a shape or location of the physical device, and non-tangible sensor data, which may be fused to a final dynamic digital twin. A digital twin, therefore, can include a static part, sensors for sensing static and dynamic data and a simulation or emulation model.

The static part of a digital twin includes a geometry model that represents the 3D shape or GIS Information of its counter-parted object. The model can be created using 2D/3D computer aided design (CAD) model, a geographic map or an assembly of multiple CAD components, or by measuring or laser scanning tangible ("physical") objects in order to clone the physical space or device by sampling the discrete points and then reconstructing them into faces and edges, by way of example.

The static part of the digital twin model also includes static sensors. Static sensors can be tagged to the geometry model. The geometry model functions as the reference to identify the relative location of every sensor in the digital model.

The dynamic part of the digital twin can comprise real-time data derived from changes in the state or behavior of the twin or its contents. Dynamic sensors, for example, can provide real-time data from changes in state/behavior of the twin or its contents. Many digital twin systems are created in a "fusion model" that integrates the real-time sensor data and the data computed from simulation or emulation techniques.

The historical data for the twin state and behavior can provide the useful projection for the physical object or process to predict their future behavior and state. Therefore, digital twins are used, for example, to optimize the operation and maintenance of physical assets, systems and manufacturing processes, and are a formative technology for the Industrial Internet of Things, where physical objects can live and interact with other machines and people virtually.

Although digital twins and their application are known in the art, it is currently difficult to effectively bring a static digital twin to life and to reliably obtain and transmit dynamic data in real time. Specifically, digital twins can be prone to poorly sensed data and delays in transmission, which can interfere with the ability of the system to adequately represent actual operation of a device. This disclosure addresses these and other issues.

US2018/0054376 discloses an Internet of Things ("IoT") associate to facilitate implementation of a digital twin of a twinned physical system. The IoT associate may include a communication port to communicate with at least one component, the at least one component comprising a sensor or an actuator associated with the twinned physical system, and a gateway to exchange information via the IoT. A computer processor and local data storage, coupled to the communication port and gateway, may receive a digital twin model from a data warehouse via the IoT. The computer processor may be programmed to, for at least a selected portion of the twinned physical system, execute the digital twin model in connection with the at least one component and operation of the twinned physical system.

"Integration of RFID into Wireless Sesnsor Networks: Architectures, Opportunities and Challenging Problems", Zhang et al, 1 October 2006, discloses a system architecture which combines RFID and WSN. US 2016/357525 A1 discloses an example of autonomous mobile sensor movement path simulation with an integrated developer environment (IDE). "The integration of Wieless Sensor Networks and RFID for pervasive computing", Xin Shi et al, 30 November 2010 discloses integrations of RFID and WSN. EP3208757A1 discloses a computer-implemented method for tracking production in a production facility and for obtaining searchable production records. "Distributed event-based resource-oriented EPCglobal middleware using GPC", Tolcha Yalew et al, 21 September 2016, discloses a resource-oriented event-based middleware into EPCglobal architecture for IoT framework. US2018/210436 A1 discloses a method of process monitoring of an industrial process involving a tangible run an industrial facility including providing an integrated facility digital twin (DT). US 2016/247129 A1 discloses a system for using digital twins for scalable, model-based machine predictive maintenance comprising a plurality of digital twins and a simulation platform. CN 110 717 985 A discloses a construction method of a building digital twinning platform. Fda: "Radio Frequency Identification (RFID)", 17 September 2018, pages 1-4 discloses examples of RFID systems. US 2018/152518 A1 discloses a system and method of controlling data transmission from a device connected to a gateway including: determining a resource utilization rate of the gateway, and determining a data processing method of the device in accordance with the utilization rate of the gateway.

### SUMMARY OF THE DISCLOSURE

The invention is defined by the subject-matter of the independent claims.

In one aspect, the present disclosure provides a system for constructing a dynamic digital twin. The system includes a plurality of energy-harvesting sensors monitoring at least one physical parameter in real time; a reader reading sensor data produced by the energy-harvesting sensors; an internet of things hub in communication with the reader; and data storage storing a physical geometric model of a physical object or space correlating with the energy-harvesting sensors. A processor in communication with the internet of things hub and the data storage is programmed to receive sensor data from the internet of things hub and physical geometric model data from the data storage, to correlate the sensor data with the physical geometric model of a physical object or space, and to fuse the sensor data with the physical geometric model to produce a digital twin. A server in communication with the internet of things hub can host the dynamic digital twin.

The communications between the energy-harvesting sensors can be provided using a low-level reader protocol (LLRP) or the high-level SDK (Software Development Kit) provided by the sensor manufacturer. The communications between the reader and the gateway and between the gateway and the internet of things hub are provided using Message Querying Telemetry Transport (MQTT), or HTTP/HTTPS protocol. The reader can be one of a Wi-Fi reader, a narrow band internet of things reader, or a wireless communications protocol.

The internet of things hub (IoT hub), the data storage, and the fusion process can be provided in an internet of things Platform as a Service (IoT PAAS). A gateway can be provided in communication with the reader and the internet of things hub, and can acquire sensor data from the reader and provide the data to the internet of things hub.

The energy-harvesting sensors can be passive RFID sensors. The passive RFID sensors can produce a unique identifier, and the processor can be programmed to identify the sensor based on the unique identifier. The physical geometric model can be a computer aided design model of the physical space or object, or a geographic map, and can comprises a location of each of the plurality of energy-harvesting sensors.

The processor can be further programmed to provide a simulation model and to incorporate the sensor data in the simulation model.

In another aspect, the present disclosure provides a method for producing a dynamic digital twin. The method comprises the steps of acquiring real-time sensor data with an energy-harvesting sensor; transmitting the acquired sensor data to a data fusion processor; associating the acquired sensor data with data defining a physical space or object associated with the sensor; fusing the sensor data and the data defining the physical object; and constructing a digital twin of the physical space or object including the sensor data.

The energy-harvesting sensor can be a passive RFID sensor which can transmit a unique identifier (UID) to the reader. The digital twin can provide at least one of asset tracking, process planning, monitoring, and data visualization.

These and other aspects of the invention will become apparent from the following description. In the description, reference is made to the accompanying drawings which form a part hereof, and in which there is shown a preferred embodiment of the invention. The invention is defined by the scope of the claims.

### BRIEF DESCRIPTION OF THE DRAWINGS

Fig. 1 is a diagram illustrating a system for constructing a digital twin in accordance with the disclosure;
Fig. 2 is a flow chart illustrating the flow of data in a system of the type of Fig. 1;
Fig. 3 is a diagram illustrating a system architecture of a digital twin system in an internet of things environment; and
Fig. 4 is a data flow chart illustrating a flow of data in a digital twin system of the type illustrated in Figs. 1 and 3.

### DETAILED DESCRIPTION OF THE DISCLOSURE

The current disclosure addresses a method for producing a digital twin in which the dynamic digital twin corresponds to a non-tangible object or parameter, such as temperature, moisture, humidity, movement, barometric or differential pressure, conductivity, voltage/potential, impedance, proximity, strain, and presence sensing. Sensing is achieved using energy harvesting sensors based on RFID or BLE technology. The dynamic digital twin may then be attached to or associated with the digital twin of a physical object to represent behavior of an object in a process, such as a part being removed from an oven. Here, creation of a living digital twin therefore starts with real time sensing by energy harvesting sensors followed by reading of sensor data, acquiring and supplementing data by a gateway, and forwarding to an internet-of-things hub (IoT HUB). With the acquired data, an abstract dynamic digital twin (for example, a temperature curve) can be created, and then associated with a physical object, thus enabling retrospective as well as prospective analysis (e.g. via Artificial Intelligence) on the behavior of an object. The current disclosure enables simulations of wear time, product life cycle, stability, etc. by quickly and efficiently providing sensor data related to parameters and associating that data with a physical object or place.

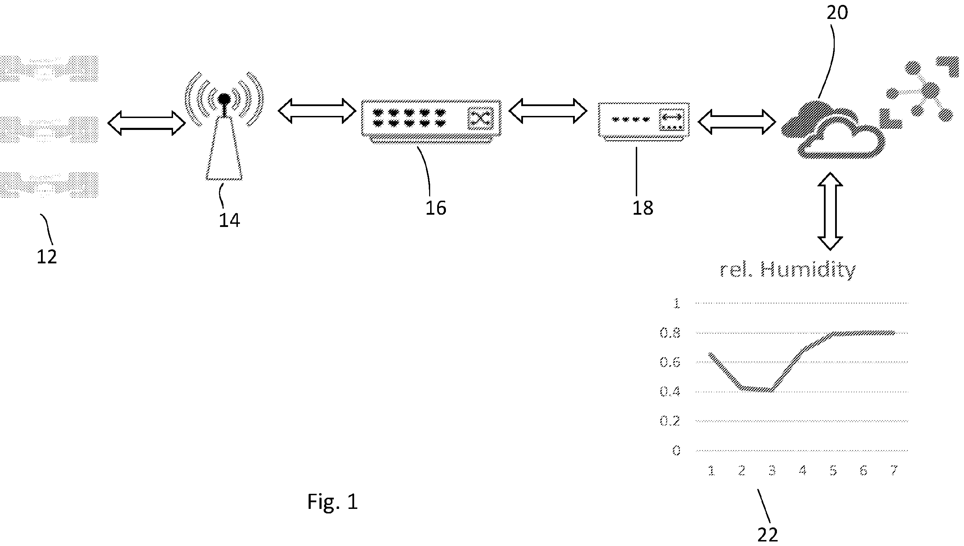

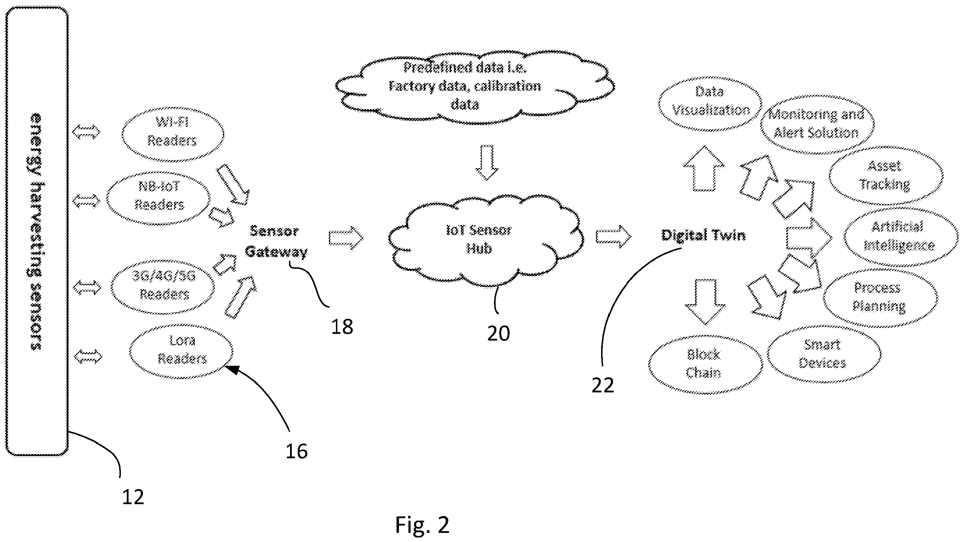

Referring now to Fig. 1, a digital twin sensor system 10 constructed in accordance with the current disclosure is shown. As illustrated here, the system comprises sensors 12 in communication with an antenna 14, such as an RFID antenna. Data from the antenna 14 is received at a reader 16. From the reader 16, data is transmitted to a gateway 18, and then to an endpoint 20. Referring now also to Fig. 2, from the endpoint 20, the digital twin 22 can be constructed and accessed by external systems to provide various data visualization and monitoring functions.

Referring still to Figs. 1 and 2, sensors 12, such as RFID sensors, can be placed in or on objects where a change of state is anticipated. Each sensor 12 has a unique identifier (UID), which can be a Transponder ID (TID) or an Electronic Product Code ID (EPC ID). This unique ID (UID) is attached to any data or signals emitted by the sensor 12 in order to identify and correlate a series of data from a single sensor. The sensors are preferably battery-less, i.e. energy harvesting sensors. That is, the sensors can derive energy from external sources. The RFID can, for example, be a passive RFID, which derives energy from the RFID reader field. The RFID sensors can be provided on chips that can use an identification number encoded to automatically identify and track tags attached to objects. Passive RFID sensors can be particularly advantageous in that they are inexpensive as compared to other sensor technology, thereby allowing for massive or redundant deployment of the sensors to ensure the accuracy and full coverage. The sensor can be read from a reading device using UHF technologies, and can be positioned a distance of a few meters or more from the receiver. Additionally, the reader can collect the data spontaneously from multiple sensors

Although passive RFID sensors can be used, alternatively, the battery-less sensors can be sensors which can capture and store energy derived through solar power, thermal energy, wind energy, salinity gradients, and kinetic or ambient energy. The sensors further can operate using various types of wireless technology such as the RFID, as described above, or Bluetooth Low Energy (BLE) technology. Other appropriate wireless technologies will be apparent to those of skill in the art.

As described above, typical sensors 12 can monitor temperature, moisture, humidity, movement (accelerometer), barometric or differential pressure, conductivity, voltage / potential, impedance, proximity, strain, or presence (identification of the presence of an object within a defined space).

The reader 16 generates the signal that will be transmitted by the antenna 14, and receives the return signals from the sensor 12. The antenna 14 emits the radio waves to communicate with the sensor 12, which energize the sensor 12 thereby allowing the sensor 12 to perform computations of state changes while energized. The results of each computation are transmitted back to the antenna 14 together with the UID that unambiguously identifies the sensor and the data or signal is captured by the reader 16. The reader 16 can include a processor that can produce the signal for transmission to the sensor, and decode and process the sensor signals internally. The processor may also process received sensor data, such as, for example, to aggregate multiple signals into one value (e.g. 10 cycles of temperature signals to produce one averaged temperature value). The reader 16 can also include a communications interface that can communicate with the gateway using WiFi, NB-IoT, cellular telephone communication protocols such as 3G, 4G and 5G, LoRa protocols, or other protocols (See Fig. 2). The reader device 16 will also typically include a memory component and may include a user interface. Although the antenna 14 is illustrated in Fig. 1 as a separate component, as illustrated, for example, in Fig. 2, the antenna can form part of the reader device 16.

The gateway 18 acquires the final sensor value from the reader 16, and may also determine a location of the sensor 12. The gateway 18 may collect data from several readers simultaneously to enable triangulation. Alternatively, reader coordinates may be used to identify the locations of the sensors 12.

The gateway 18 then packages the value into a message that can be transmitted through a communications interface using wireless network or internet communication protocols including, for example, MQTT, Advanced Message Queuing Protocol (APMQ), HTTP, HTTPS, or those discussed above, by way of example. The gateway 18 transmits the data to an endpoint 20 which is configured to accept and process the message. Triangulation data may be combined to derive location information for the sensor either at the gateway 18, endpoint 20 or at the reader device 16. The gateway 18 can also include a processor, and can process data by integrating data from multiple readers to produce more consistent, accurate and useful information than that provided by any individual data sources.

Blockchain technology or other encryption or security measures can be used to make data tamper-proof in any of the communications described herein.

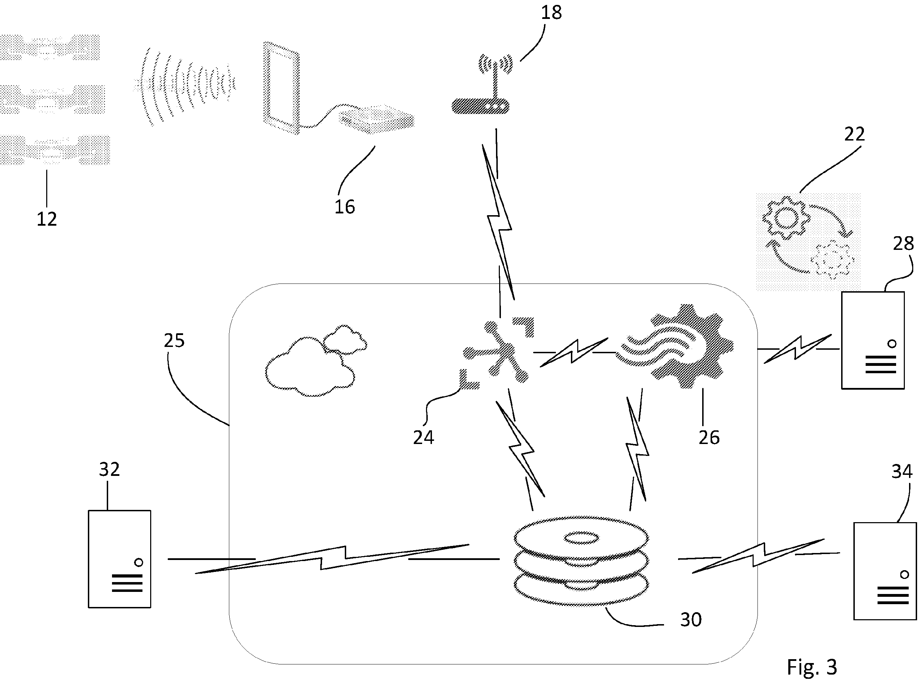

As described above, the endpoint 20, can collect the messages, extract the sensor value (temperature, moisture, etc.) and route the value to the intended destination (digital twin 22) according to stored rules. The stored rules can be customizable to provide different types of data and different calculations, depending on the application. The endpoint 20 can be, as shown, a cloud-based Internet-of-Things (IOT) hub, a remote computer or server, or various types of local area and wide area networks, including both wired and wireless systems, or a combination of these devices, which can together form a platform as a Service (PaaS), as illustrated in Fig. 3, discussed below.

The sensor data and sensed parameters can then be used by a computing device including a processor, to create a digital twin 22, as illustrated in Fig. 2. The digital twin 22 may be attached to/associated with a physical object to represent the behavior of the physical object over time and in specific sensed conditions. The digital twin 22 can be used in data visualization processes, monitoring systems, asset tracking, and other processes as illustrated in Fig. 2. The digital twin 22 thereby enables simulations of wear time, product life cycle, stability, warning scenarios (e.g. mold growth in buildings due to moisture), and other scenarios as described in the examples below.

Referring now to Fig. 3, a system architecture of a digital twin in an internet-of-things (IoT) system constructed in accordance with the present disclosure is shown. A plurality of battery-less energy harvesting sensors 12 are positioned to acquire data. As described above, each sensor 12 can be a passive RFID chip that includes a unique identifier (UTD). With passive RF technology, the sensor data can be collected with an electromagnetic signal. By leveraging the impedance embedded in the circuit, the RFID integrated circuit chip can respond to changes of environmental physics with the shift of radio frequency. The change in the radio frequency can then be detected and converted into the digital measurement. RFID chips can also generate an identification number encoded into its IC that automatically identifies and tracks the sensors. A processor can be programmed to identify the sensor data based on the unique identifier, as described below.

The data acquired from sensors 12 can be wirelessly transmitted to reader 16, which then wirelessly transmits the data to gateway 18, which is in communication with an internet-of-things (IoT) hub 24. The internet of things hub 24 is in communication with data storage 30, which can, for example, be in communication with external computers or servers 32 and 34, such as an enterprise resource planning (ERP) system. The IoT hub 24 communicates with a sensor or data fusion processor 26 which, again, is in communication with data storage 30. The output of the data fusion processor 26 is provided to a computer or server 28 which hosts the digital twin 22. Information acquired can also be transmitted to computers or networks 34 for analysis.

Although various communications protocols can be used, in one embodiment, the sensor 12 transmits data to the reader 16 using Low Level Reader Protocol (LLRP), a RFID aware protocol that provides a standard network interface to RFID readers, and therefore provides a standard data format for use downstream. The reader 16 can transmit to the gateway 18 using MQTT, a lightweight publish-subscribe network protocol that transports messages between devices, typically using TCP/IP protocol. The IoT hub 24, data fusion processor 26, and data storage 30 can be advantageously provided on the cloud, such as an IoT Platform as a Service (PaaS) 25 which provides a managed cloud platform which can store, transfer, and manage or process acquired data, and enables connected devices to easily and securely interact with cloud applications and other devices. PaaS systems are known in the art and include, by way of example, Azure/IoT and AWS/IoT. Further, although a specific PaaS system is described, various cloud based services that provide processing and data storage can be used. Further, the IoT hub can be provided in a central server of a local area network that provides the data acquisition and data integration processes described above. Various other types of wired and wireless networks that include data storage and processing capabilities may also be used.

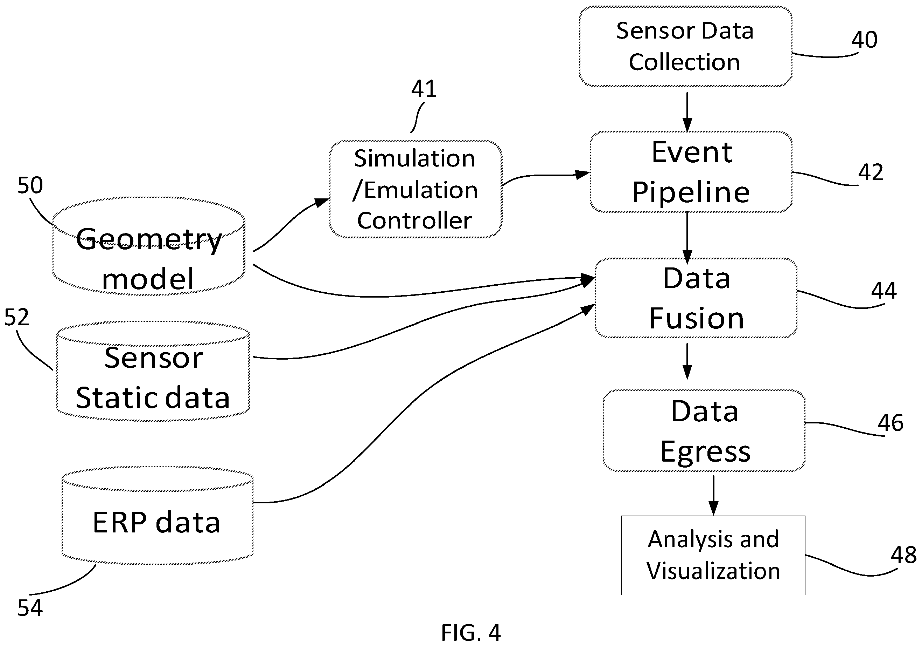

Referring now also to Fig. 4, a flow chart illustrating the flow of data in the system of Fig. 3 is shown. Initially, in step 40, sensor data is collected from sensors 12 as described above. The collected data then is transmitted the gateway 18 and enters in event pipeline in step 42. In the data fusion processor 26, the collected sensor data is combined such that the resulting information has less uncertainty than would be possible if the sources were used individually, providing a more accurate, more complete, and more dependable result. The sensor or data fusion can use algorithms such as central limit theorem, Kalman filters, Bayesian networks, Dempster-Shafer, and convolutional neural networks. The sensor data can also be combined with geometric modeling data from stored shape or geometry model 50, sensor static data 52, and ERP data 54. After the data fusion processor 26 fuses the sensor data, the fused data enters a data egress step 46, in which the data is transmitted to server 28 for use in visualizing and analyzing the digital twin 22, as illustrated in step 48. As illustrated, a simulation or emulation controller 41 may receive geometric model data 50 and provide a simulation to the event pipeline 42. The simulation engine or emulation controller 41 can be used to continuously interpolate between discrete data states produced by the incoming sensor data, and trigger the pipeline of events 42. For example, if an RFID sensor collect the temperature every 10 seconds, the simulation engine can calculate the temperature of the intermediate data points and manage the changes or the sensor data in order.

### Examples

The processes described above can be used in constructing many types of digital twins. Examples of digital twin systems can include, for example, a "Bridge," where sensors can monitor corrosion and/or ageing of concrete through conductivity, strain and other sensors, and pressure sensors to indicate traffic load, or simulate future behavior in terms of stability etc.

In another example, the digital twin system can be a "Building." Here, sensors can include moisture, temperature, and barometric pressure. The sensor data can be used to control air conditioning and monitor the building "health" in terms of, for example, mold prevention.

In still another example, the digital twin can be a "Smart Factory." Here, sensors can be provided on machines, parts or components, other equipment, and within the building. Sensor data can be used to provide efficient production planning, machine maintenance, machine down time planning, and in similar operations.

In yet another example, the digital twin can be a "Product Life Cycle Management" system. Here, for example, items can be tagged when produced or when initially put into use with sensor or sensor-less RFID or BLE tags. Sensors can be used to monitor wear and threshold temperature. The data can also be used for tracking and forecasting a product life cycle ("cradle to grave") or recyclability of a product ("cradle to cradle").

In still another example, the digital twin can be used in an "Agriculture" or "farm to truck" tracking system. Here, the sensors can monitor, for example, soil moisture to prevent problems such as chronic over-irrigation, or monitor unprocessed/cooked food to minimize spoilage due to bacteria, mold and mildew. Sensors can also monitor humidity, salinity, or fertilizers, particularly in indoor greenhouses/farms to maximize yield.

In yet still another example, the digital twin can be used in an "Automotive" system. Here, for example, moisture sensing can be used to confirm waterproofing, and temperature sensing can be used to confirm insulation effectiveness. Temperature sensing can also be used to confirm paint cure and laminate cure.

In another example, the digital twin can be used in "Aerospace" systems. Here, for example, motion sensing can be used to detect excessive vibration limits of airframe components. Temperature sensing can be used to monitor interior surface or compartment upper/lower limits, and pressure sensing can be used to detect presence of leaks in pressurized compartments.

In still another example, the digital twin can be used in "Healthcare" systems. Here, moisture sensing can be used to detect excess dampness of bedclothes, sheets and diapers indicating bleeding, urine, etc. Further, sensors can be used to identify tampering on lockers, bottles, cabinets, etc., or to detect when various seals have been broken.

Although specific examples are given here, it will be apparent that many different types of digital twins can be constructed. A digital twin can, for example, provide a clone of a physical space such as buildings, vehicles (aircraft, cars, ships), agricultural environments (farm fields/orchards/vineyards). In addition the digital twin can provide a clone of the contents of the physical space, which can include, for example, machines, rooms, building materials, control systems, HVAC, and sensors. The digital twin can also provide a clone of the behavior or state of the physical space and its contents, such as temperature, humidity/moisture content, location, speed, barometric pressure, acceleration, and an analysis of whether a device is sealed or broken. Many other sensors and models will be apparent to those of skill in the art.

Although preferred embodiments have been described, it will be apparent that a number of revisions could be made within the scope of the claims. For example, although specific hardware and communication protocols are described in detail above, it will be apparent that variations in both hardware and communications systems can be used. As described above, an antenna can be provided as part of the reader device. Calculations, further, can be performed at any number of different locations in the system, including the reader, the gateway, or the endpoint.

To apprise the public of the scope of this invention, the following claims are made:

## Claims

1. A system for constructing a dynamic digital twin, the system comprising:
at least one battery-less passive RFID sensor (12) configured to monitor at least one physical parameter in real time;
a plurality of readers (16) configured to wirelessly read sensor data produced by the at least one battery-less passive RFID sensor;
a gateway (18) in communication with each reader (16), the gateway (18) being configured to acquire sensor data from each reader (16) and integrate the sensor data from each reader (16);
an internet of things hub (24) in communication with the gateway (18),
wherein the gateway (18) is arranged to communicate the sensor data to the internet of things hub;
data storage (30) storing a physical geometric model of a physical object or space correlating with the at least one battery-less passive RFID sensor;
a processor (26) in communication with the internet of things hub (24) and the data storage (30), the processor (26) programmed to receive sensor data from the internet of things hub (24) and physical geometric model data from the data storage (30), to correlate the sensor data with the physical geometric model (50) of the physical object or space, and to fuse the sensor data with the physical geometric model of the physical object or space to construct a dynamic digital twin (22).

2. The system of claim 1, further comprising a server in communication with the internet of things hub (24), the server hosting the digital twin (22).

3. The system of claim 1, wherein communications between the passive RFID sensors (12) are provided using a low-level reader protocol, LLRP.

4. The system of claim 1, wherein communications between the reader (16) and the gateway (18) and between the gateway (18) and the internet of things hub (24) are provided using one of:
Message Queue Telemetry Transport, MQTT; or
HTTP/HTTPS protocol.

5. The system of claim 1, wherein the internet of things hub (24), the data storage (30), and the process are provided in an internet of things Platform as a Service, IoT PaaS (25).

6. The system of claim 1, wherein the passive RFID sensors (12) produce unique identifier, and wherein the processor (26) is programmed to identify the sensor (12) based on the unique identifier.

7. The system of claim 1, wherein the physical geometric model is one of
a computer aided design model of the physical space or object; or
a geographic map.

8. The system of claim 1, wherein the physical geometric model (50) comprises a location of each of the plurality of passive RFID sensors.

9. The system of claim 1, wherein the processor (26) is further programmed to provide a simulation model and to incorporate the sensor data in the simulation model.

10. The system of claim 1, where the reader (16) is at least one of a Wi-Fi reader, a narrow band internet of things reader, or a wireless communications protocol.

11. The system of claim 1, wherein the internet of things hub (24), the data storage (30), and the process are provided on a server in a local area network.

12. A method for constructing a dynamic digital twin (22), the method comprising the following steps:
acquiring real-time sensor data with at least one battery-less passive RFID sensor (12), the acquiring comprising wirelessly reading, by a plurality of readers (16), sensor data produced by the at least one battery-less passive RFID sensor;
acquiring, by a gateway (18) in communication with each reader (16), the sensor data from each of the plurality of readers (16);
integrating, by the gateway (18), the acquired sensor data from each of the plurality of readers (16);
communicating the sensor data from the gateway (18) to an internet of things hub (24);
transmitting the acquired sensor data from the internet of things hub (24) to a data fusion processor (26);
correlating the acquired sensor data with data defining a physical geometric model of a physical space or object associated with the sensor;
fusing the sensor data and the data defining the physical geometric model (50) of the physical object; and
constructing a dynamic digital twin (22) of the physical geometric model (50) of the physical space or object including the sensor data.

13. The method of claim 12, wherein the method comprises transmitting, by the passive RFID sensor (12), a unique identifier (UID) to the reader.

14. The method of claim 12, further comprising the step of using the digital twin (22) to provide at least one of asset tracking, process planning, monitoring, and data visualization.

15. The method of claim 12, further comprising the step of interpolating between discrete readings of the sensor data.

## Patentansprüche

1. System zum Konstruieren eines dynamischen digitalen Zwillings, wobei das System Folgendes umfasst:
zumindest einen batterielosen passiven RFID-Sensor (12), der konfiguriert ist, um zumindest einen physischen Parameter in Echtzeit zu überwachen;
eine Vielzahl von Lesegeräten (16), die konfiguriert ist, um Sensordaten, die durch den zumindest einen batterielosen passiven RFID-Sensor produziert werden, drahtlos zu lesen;
ein Gateway (18) in Kommunikation mit jedem Lesegerät (16), wobei das Gateway (18) konfiguriert ist, um Sensordaten von jedem Lesegerät (16) zu erfassen und die Sensordaten von jedem Lesegerät (16) zu integrieren;
einen Internet-of-Things-Hub (24) in Kommunikation mit dem Gateway (18), wobei das Gateway (18) angeordnet ist, um die Sensordaten an den Internet-of-Things-Hub zu kommunizieren;
Datenspeicher (30), der ein physisches geometrisches Modell eines physischen Objekts oder Raums speichert, das mit dem zumindest einen batterielosen passiven RFID-Sensor korreliert;
einen Prozessor (26) in Kommunikation mit dem Internet-of-Things-Hub (24) und dem Datenspeicher (30), wobei der Prozessor (26) programmiert ist, um Sensordaten von dem Internet-of-Things-Hub (24) und physische geometrische Modelldaten von dem Datenspeicher (30) zu empfangen, um die Sensordaten mit dem physischen geometrischen Modell (50) des physischen Objekts oder Raums zu korrelieren und um die Sensordaten mit dem physischen geometrischen Modell des physischen Objekts oder Raums zu fusionieren, um einen dynamischen digitalen Zwilling (22) zu konstruieren.

2. System nach Anspruch 1, ferner umfassend einen Server in Kommunikation mit dem Internet-of-Things-Hub (24), wobei der Server den digitalen Zwilling (22) hostet.

3. System nach Anspruch 1, wobei Kommunikation zwischen den passiven RFID-Sensoren (12) unter Verwendung eines Low-Level-Lesegerät-Protokolls, LLRP, bereitgestellt ist.

4. System nach Anspruch 1, wobei Kommunikation zwischen dem Lesegerät (16) und dem Gateway (18) und zwischen dem Gateway (18) und dem Internet-of-Things-Hub (24) unter Verwendung von einem des Folgenden bereitgestellt ist:
Message Queue Telemetry Transport, MQTT; oder
HTTP/HTTPS-Protokoll.

5. System nach Anspruch 1, wobei der Internet-of-Things-Hub (24), der Datenspeicher (30) und der Prozess in einer Internet-of-Things-Plattform als Service, IoT PaaS (25) bereitgestellt sind.

6. System nach Anspruch 1, wobei die passiven RFID-Sensoren (12) eindeutige Kennung produzieren und wobei der Prozessor (26) programmiert ist, um den Sensor (12) basierend auf der eindeutigen Kennung zu identifizieren.

7. System nach Anspruch 1, wobei das physische geometrische Modell eines von Folgendem ist:
einem computergestützten Designmodell des physischen Raums oder Objekts; oder
einer geografischen Karte.

8. System nach Anspruch 1, wobei das physische geometrische Modell (50) einen Standort von jedem aus der Vielzahl von passiven RFID-Sensoren umfasst.

9. System nach Anspruch 1, wobei der Prozessor (26) ferner programmiert ist, um ein Simulationsmodell bereitzustellen und um die Sensordaten in das Simulationsmodell einzubinden.

10. System nach Anspruch 1, wobei das Lesegerät (16) zumindest eines von einem Wi-Fi-Lesegerät, einem Schmalband-Internet-of-Things-Lesegerät oder einem Drahtloskommunikationsprotokoll ist.

11. System nach Anspruch 1, wobei der Internet-of-Things-Hub (24), der Datenspeicher (30) und der Prozess auf einem Server in einem lokalen Netzwerk bereitgestellt sind.

12. Verfahren zum Konstruieren eines dynamischen digitalen Zwillings (22), wobei das Verfahren die folgenden Schritte umfasst:
Erfassen von Echtzeitsensordaten mit zumindest einem batterielosen passiven RFID-Sensor (12), wobei das Erfassen drahtloses Lesen, durch eine Vielzahl von Lesegeräten (16), von Sensordaten umfasst, die durch den zumindest einen batterielosen passiven RFID-Sensor produziert werden;
Erfassen, durch ein Gateway (18) in Kommunikation mit jedem Lesegerät (16), der Sensordaten von jedem aus der Vielzahl von Lesegeräten (16);
Integrieren, durch das Gateway (18), der erfassten Sensordaten von jedem aus der Vielzahl von Lesegeräten (16);
Kommunizieren der Sensordaten von dem Gateway (18) an einen Internet-of-Things-Hub (24);
Übertragen der erfassten Sensordaten von dem Internet-of-Things-Hub (24) an einen Datenfusionsprozessor (26);
Korrelieren der erfassten Sensordaten mit Daten, die ein physisches geometrisches Modell eines physischen Raums oder Objekts definieren, das mit dem Sensor verknüpft ist;
Fusionieren der Sensordaten und der Daten, die das physische geometrische Modell (50) des physischen Objekts definieren, und
Konstruieren eines dynamischen digitalen Zwillings (22) des physischen geometrischen Modells (50) des physischen Raums oder Objekts, das die Sensordaten beinhaltet.

13. Verfahren nach Anspruch 12, wobei das Verfahren Übertragen, durch den passiven RFID-Sensor (12), einer eindeutigen Kennung (UID) an das Lesegerät umfasst.

14. Verfahren nach Anspruch 12, ferner umfassend den Schritt des Verwendens des digitalen Zwillings (22), um zumindest eines von Anlagenverfolgung, Prozessplanung, Überwachung und Datenvisualisierung bereitzustellen.

15. Verfahren nach Anspruch 12, ferner umfassend den Schritt des Interpolierens zwischen einzelnen Ablesungen der Sensordaten.

## Revendications

1. Système permettant la construction d'un jumeau numérique dynamique, le système comprenant :
au moins un capteur RFID passif sans batterie (12) configuré pour surveiller au moins un paramètre physique en temps réel ;
une pluralité de lecteurs (16) configurés pour lire sans fil des données de capteur produites par le au moins un capteur RFID passif sans batterie ;
une passerelle (18) en communication avec chaque lecteur (16), la passerelle (18) étant configurée pour acquérir des données de capteur provenant de chaque lecteur (16) et intégrer les données de capteur provenant de chaque lecteur (16) ;
un concentrateur de l'internet des objets (24) en communication avec la passerelle (18), ladite passerelle (18) étant agencée pour communiquer les données de capteur au concentrateur de l'internet des objets ;
un dispositif de stockage de données (30) stockant un modèle géométrique physique d'un objet ou espace physique en corrélation avec ledit au moins un capteur RFID passif sans batterie, un processeur (26) en communication avec le concentrateur de l'internet des objets (24) et le dispositif de stockage de données (30), le processeur (26) programmé pour recevoir des données de capteur en provenance du concentrateur de l'internet des objets (24) et des données de modèle géométrique physique en provenance du dispositif de stockage de données (30), pour corréler les données de capteur avec le modèle géométrique physique (50) de l'objet ou espace physique, et pour fusionner les données de capteur avec le modèle géométrique physique de l'objet ou espace physique pour construire un jumeau numérique dynamique (22).

2. Système de la revendication 1, comprenant en outre un serveur en communication avec le concentrateur de l'internet des objets (24), le serveur hébergeant le jumeau numérique (22).

3. Système de la revendication 1, lesdites communications entre les capteurs RFID passifs (12) étant assurées à l'aide d'un protocole de lecteur de bas niveau, LLRP.

4. Système de la revendication 1, lesdites communications entre le lecteur (16) et la passerelle (18) et entre la passerelle (18) et le concentrateur de l'internet des objets (24) étant assurées en utilisant un parmi :
un protocole de transport de télémétrie de file d'attente de message, MQTT ; ou
un protocole HTTP/HTTPS.

5. Système de la revendication 1, ledit concentrateur de l'internet des objets (24), ledit dispositif de stockage de données (30) et ledit processus étant fournis dans une plate-forme de l'internet des objets en tant que service, IoT PaaS (25).

6. Système de la revendication 1, lesdits capteurs RFID passifs (12) produisant un identifiant unique, et ledit processeur (26) étant programmé pour identifier le capteur (12) sur la base de l'identifiant unique.

7. Système de la revendication 1, ledit modèle géométrique physique étant un parmi :
un modèle de conception assistée par ordinateur de l'espace ou objet physique ; ou
une carte géographique.

8. Système de la revendication 1, ledit modèle géométrique physique (50) comprenant un emplacement de chacun de la pluralité de capteurs RFID passifs.

9. Système de la revendication 1, ledit processeur (26) étant en outre programmé pour fournir un modèle de simulation et pour incorporer les données de capteur dans le modèle de simulation.

10. Système de la revendication 1, ledit lecteur (16) étant au moins l'un d'un lecteur Wi-Fi, d'un lecteur de l'internet des objets à bande étroite ou d'un protocole de communication sans fil.

11. Système de la revendication 1, ledit concentrateur de l'internet des objets (24), ledit dispositif de stockage de données (30) et ledit processus étant fournis sur un serveur dans un réseau local.

12. Procédé permettant la construction d'un jumeau numérique dynamique (22), le procédé comprenant les étapes suivantes :
l'acquisition des données de capteur en temps réel avec au moins un capteur RFID passif sans batterie (12), l'acquisition comprenant la lecture sans fil, par une pluralité de lecteurs (16), de données de capteur produites par le au moins un capteur RFID passif sans batterie ;
l'acquisition, par une passerelle (18) en communication avec chaque lecteur (16), des données de capteur provenant de chacun de la pluralité de lecteurs (16) ;
l'intégration, par la passerelle (18), des données de capteur acquises provenant de chacun de la pluralité de lecteurs (16) ;
la communication des données de capteur de la passerelle (18) à un concentrateur de l'internet des objets (24) ;
la transmission des données de capteur acquises provenant du concentrateur de l'internet des objets (24) à un processeur de fusion de données (26) ;
la corrélation des données de capteur acquises avec des données définissant un modèle géométrique physique d'un espace ou objet physique associé au capteur ;
la fusion des données de capteur et des données définissant le modèle géométrique physique (50) de l'objet physique ; et
la construction d'un jumeau numérique dynamique (22) du modèle géométrique physique (50) de l'espace ou objet physique comprenant les données de capteur.

13. Procédé de la revendication 12, ledit procédé comprenant la transmission, par le capteur RFID passif (12), d'un identifiant unique (UID) au lecteur.

14. Procédé de la revendication 12, comprenant en outre l'étape d'utilisation du jumeau numérique (22) pour fournir au moins l'un du suivi d'actifs, de la planification de processus, de la surveillance et de la visualisation de données.

15. Procédé de la revendication 12, comprenant en outre l'étape d'interpolation entre des lectures discrètes des données de capteur.
